# EUROPEAN PATENT APPLICATION

(11) **EP 1 077 528 A2**
(43) Date of publication of application: **21.02.2001**
(21) Application number: 00116960.6
(22) Date of filing: 07.08.2000
(51) Int. Cl.: H03H 7/21, H03H 7/01

(54) **Three-terminal filter, receiving module, and portable radio apparatus**

(30) Priority: 19.08.1999 JP 23263899
(71) Applicant: Murata Manufacturing Co., Ltd., Nagaokakyo-shi Kyoto-fu 617-8555 (JP)
(72) Inventor: Ishii, Takehito, Nagaokakyo-shi, Kyoto-fu 617-8555 (JP); Shimada, Norihiro, Nagaokakyo-shi, Kyoto-fu 617-8555 (JP); Tonegawa, Ken, Nagaokakyo-shi, Kyoto-fu 617-8555 (JP)
(74) Representative: Schoppe, Fritz, Dipl.-Ing.

(57) **Abstract**

A three-terminal filter, a receiving module, and a portable radio apparatus which are small in size, thin in form, light in weight, and low in price. A three-terminal filter (10) has inductors (L11-L13) and capacitors (C11-C14), an input terminal (Pi) for inputting a high-frequency signal, a first output terminal (Po1) for outputting a first high-frequency signal, and a second output terminal (Po2) for outputting a second high-frequency signal. The high-frequency signal passes through a high-pass filter having the inductors (L11, L12) and the capacitors (C11, C12), thereafter, is outputted as a first high-frequency signal from the first output terminal (Po1) via the capacitor (C13), and is outputted as a second high-frequency signal from the second output terminal (Po2) via the inductor (L13).

## Description

### BACKGROUND OF THE INVENTION

### 1. Field of the Invention

The present invention relates to a three-terminal filter, a receiving module, and a portable radio apparatus, more particularly, to a three-terminal filter, a receiving module, and a portable radio apparatus for use in a receiving unit in a cellular phone, pager, etc.

### 2. Description of the Related Art

Generally in a portable radio apparatus such as a cellular phone, a prime problem is to achieve miniaturization and light weight and, further, high performance and low price.

Further, it is known to be most suitable to use a double-balanced mixer for mutual modulation in a frequency converting unit in a receiving unit. The double-balanced mixer should have excellent distortion characteristics and should highly suppress a local oscillation signal.

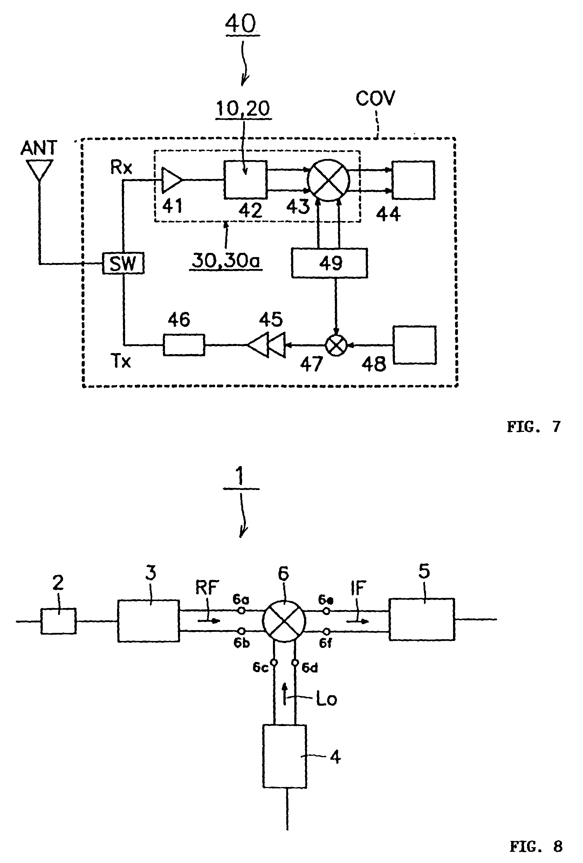

Fig. 8 is a block diagram showing a frequency-converting unit of a receiving unit in a cellular phone. A frequency-converting unit 1 comprises a high-pass filter 2, baluns 3 to 5, and a double-balanced mixer 6. A high frequency signal RF and a local oscillation signal Lo, whose phases are different by 180° from each other, are supplied to high-frequency signal input terminals 6a and 6b and local-oscillation signal input terminals 6c and 6d in the double-balanced mixer 6, respectively. Each of the baluns 3 and 4 converts an unbalanced signal into a balanced signal. Intermediate-frequency signals IF whose phases are different by 180° from each other are outputted from intermediate-frequency signal output terminals 6e and 6f. Then the balun 5 converts the balanced signal IF into an unbalanced signal.

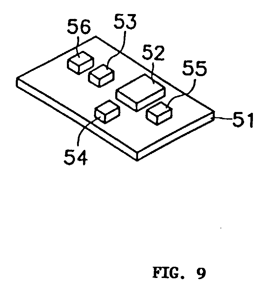

Fig. 9 is a perspective view of the frequency-converting unit. Mounted onto a printed board 51 are an IC 52 serving as a double-balanced mixer, baluns 53 and 54 which are surface mounted components, a high-pass filter 55, and an IC 56 which comprises a low-noise amplifier.

Technological progress has led to improvements in IC configuration and in miniaturization of the IC package and, thus, the double-balanced mixer itself has a small size and light weight. On the other hand, the balun is constructed by winding a winding on a ferrite material through which two holes are formed and is attached to a base made of a resin, and the minimum size acquirable currently is approximately (5 mm x 5 mm). Therefore, the size of balun becomes a factor which prevents the portable radio apparatus from having a small size, a thin form, and a light weight.

Further, the balun needs not only the winding on the ferrite material, but also the attachment of the balun to the resin base for the purpose of surface mounting. Thus, the cost of assembly is raised and this becomes a factor which prevents lowering the price of the portable radio apparatus.

In order to solve these problems, it is an object of the present invention to provide a three-terminal filter, a receiving module, and a portable radio apparatus which are small in size, thin in form, light in weight, and low in price.

### SUMMARY OF THE INVENTION

To solve the aforementioned problems, according to the present invention, there is provided a three-terminal filter comprising a plurality of inductors and a plurality of capacitors, and further comprises an input terminal for inputting a high-frequency signal, a first output terminal for outputting a first high-frequency signal having a predetermined frequency, a second output terminal for outputting a second high-frequency signal whose phase is inverted by 180° from a phase of the first high-frequency signal.

According to another aspect of the present invention, there is provided a three-terminal filter, which comprises a laminate constructed by laminating a plurality of dielectric layers, wherein at least one of the inductors comprises a strip line electrode which is provided in the laminate, and at least one of the capacitors comprises a plurality of capacitor electrodes which are provided in the laminate, while sandwiching the dielectric layers and facing each other.

According to another aspect of the present invention, there is provided a receiving module comprising a low-noise amplifier, a double-balanced mixer, and the three-terminal filter, wherein at least one of the low-noise amplifier and the double-balanced mixer is mounted to the laminate comprised in the three-terminal filter.

According to another aspect of the present invention, there is provided a receiving module, wherein the laminate, which the three-terminal filter comprises, has a cavity having therein at least one of the low-noise amplifier and the double-balanced mixer, which is provided therein.

According to another aspect of the present invention, there is provided a portable radio apparatus which comprises an antenna, a low-noise amplifier, the aforesaid three-terminal filter, a double-balanced mixer, and a demodulating unit.

According to another aspect of the present invention, there is provided a portable radio apparatus which comprises an antenna, the aforesaid receiving module, and a demodulating unit.

With the aforesaid three-terminal filter, it is possible to remove a signal of an image frequency that is an unnecessary signal and to convert an unbalanced signal into a balanced signal.

With the aforesaid receiving module, with at least one of a low-noise amplifier and a double-balanced mixer on or in the laminate, the size can be decreased.

Further, a portable radio apparatus with the aforesaid three-terminal filter or receiving module can be small in size.

Other features and advantages of the invention will be understood from the following detailed description of embodiments thereof, with reference to the drawings.

### BRIEF DESCRIPTION OF THE DRAWINGS

Fig. 1 is an equivalent circuit diagram of a first embodiment according to a three-terminal filter of the present invention;
Fig. 2 is an exploded perspective view of the three-terminal filter having the equivalent circuit diagram of the first embodiment in Fig. 1;
Fig. 3 is an equivalent circuit diagram of a second embodiment according to the three-terminal filter of the present invention;
Fig. 4 is a block diagram of one embodiment of a receiving module according to the present invention;
Fig. 5 is an exploded perspective view of only the receiving module in Fig. 4;
Fig. 6 is a cross-sectional view showing the modification example of the receiving module in Fig. 5;
Fig. 7 is a block diagram of one embodiment according to a portable radio apparatus of the present invention;
Fig. 8 is a block diagram showing a frequency converting unit of a receiving unit in a typical cellular phone; and
Fig. 9 is a perspective view showing a frequency converting unit of a receiving unit in the conventional cellular phone.

### DESCRIPTION OF EMBODIMENTS OF THE INVENTION

Embodiments of the present invention will be described hereinbelow with reference to the drawings.

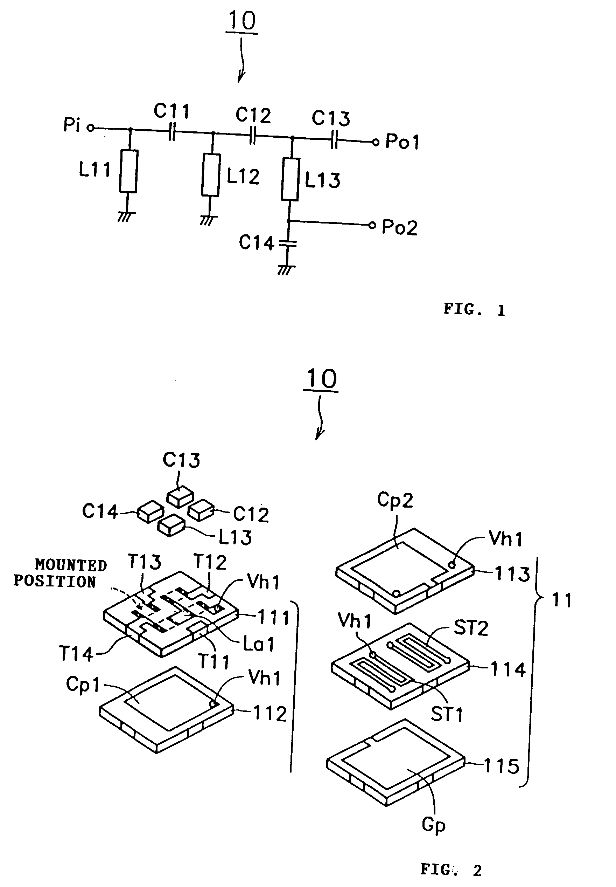

Fig. 1 is an equivalent circuit diagram of a first embodiment according to a three-terminal filter of the present invention. A three-terminal filter 10 comprises inductors L11 to L13 and capacitors C11 to C14, an input terminal Pi for inputting a high-frequency signal RF, a first output terminal Po1 for outputting a first high-frequency signal RF1, and a second output terminal Po2 for outputting a second high-frequency signal RF2.

In the operation of the three-terminal filter 10, the high-frequency signal RF, which is inputted from the input terminal Pi, passes through a high-pass filter comprising the inductors L11 and L12 and the capacitors C11 and C12, thereafter, is outputted as the first high-frequency signal RF1 from the first output terminal Po1 via the capacitor C13, and is outputted as the second high-frequency signal RF2 from the second output terminal Po2 via the inductor L13.

In this case, since the second high-frequency signal RF2 passes through the inductor L13, the phase thereof is inverted by 180° from a phase of the first high-frequency signal RF1. According to the three-terminal filter 10, the high-pass filter comprises the inductors L11 and L12 and the capacitors C11 and C12. Therefore, the three-terminal filter 10 can be used when RF signals are mixed by a double-balanced mixer with a lower local signal, and an image frequency lower than a predetermined high-frequency signal RF can be attenuated.

Fig. 2 is an exploded perspective view showing the three-terminal filter having the equivalent circuit in Fig. 1. The three-terminal filter 10 comprises a laminate 11, and external terminals T11 to T14 are provided extending from an upper surface of the laminate 11 to a lower surface thereof. In this case, the external terminal T11 corresponds to the input terminal Pi (in Fig. 1) of the three-terminal filter 10; the external terminals T12 and T14 to the second output terminals Po1 and Po2 of the three-terminal filter 10 (in Fig. 1); and the external terminal T13 to a ground terminal.

For example, the laminate 11 is formed by sequentially laminating and then firing first to fifth dielectric layers 111 to 115 made of low-temperature co-fired ceramics, which essentially contain barium oxide, aluminum oxide, and silica and can be fired at a temperature within the range of 850°C to 1000°C.

Formed onto the first dielectric layer 111 is a land La1 for mounting the inductor L13 and the capacitors C12 to C14 which comprises chip parts, respectively. Formed onto the second third dielectric layers 112 and 113 are capacitor electrodes Cp1 and Cp2.

Further, strip line electrodes ST1 and ST2 are formed onto the fourth dielectric layer 114. A ground terminal Gp is formed onto the fifth dielectric layer 115. Furthermore, several via-hole electrodes Vh1 are formed onto the first to fourth dielectric layers 111 to 114 so as to pierce the dielectric layers 111 to 114.

The inductors L11 and L12 of a microstrip line type comprise the strip line electrodes ST1 and ST2 and the ground electrode Gp, respectively. The capacitor C11 comprises the capacitor electrodes Cp1 and Cp2 which sandwich the second dielectric layer 112 and face each other.

Moreover, the strip line electrodes ST1 and ST2 and the capacitor electrodes Cp1 and Cp2 which are provided in the laminate 11, and the inductor L13 and the capacitors C12 to C14 which comprises chip parts mounted in the laminate 11, respectively, are connected through the via-hole electrodes Vh1 built into the laminate 11.

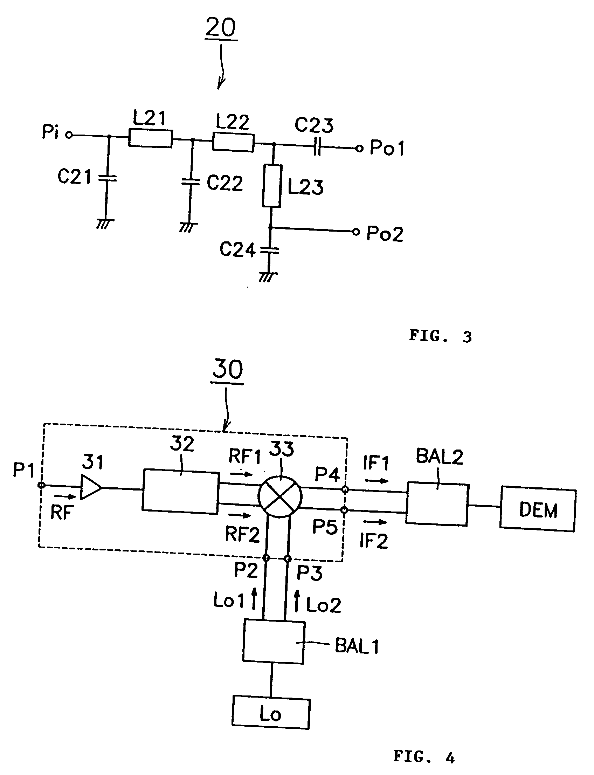

Fig. 3 is an equivalent circuit diagram of a second embodiment according to the three-terminal filter of the present invention. A three-terminal filter 20 comprises inductors L21 to L23 and capacitors C21 to C24, the input terminal Pi for inputting the high-frequency signal RF, a first output terminal Po1 for outputting the first high-frequency signal RF1, and a second output terminal Po2 for outputting the second high-frequency signal RF2.

The description turns to an operation of the three-terminal filter 20 hereinafter. The high-frequency signal RF, which is inputted from the input terminal Pi, passes through a low-pass filter comprising the inductors L21 and L22 and the capacitors C21 and C22, thereafter, is outputted as the first high-frequency signal RF1 from the first output terminal Po1 via the capacitor C23, and outputted as the second high-frequency signal RF2 from the second output terminal Po2 via the inductor L23.

In this case, since the second high-frequency signal RF2 passes through the inductor L23, the phase thereof is inverted by 180° from a phase of the first high-frequency signal RF1. According to the three-terminal filter 20, the low-pass filter comprises the inductors L21 and L22 and the capacitors C21 and C22. Therefore, the three-terminal filter 20 is used when signals are mixed by a double-balanced mixer with an upper local signal, and an image frequency higher than a predetermined high-frequency signal RF is attenuated.

According to the aforementioned embodiments, the three-terminal filter comprises an input terminal for inputting a high-frequency signal, a first output terminal for outputting a first high-frequency signal of a predetermined frequency, a second output terminal for outputting a second high-frequency signal whose phase is inverted by 180° from a phase of the first high-frequency signal. Therefore, it is possible to remove a signal of an image frequency that is an unnecessary signal and convert an unbalanced signal into a balanced signal.

Accordingly, since both a filter function and a balun function are performed by one unit, the mounting area required is approximately 2/3 of that of the conventional filter and balun, thereby making possible a decrease in size. Costs can also be reduced because of decreasing the number of parts.

Further, since the inductors and capacitors constructing the three-terminal filter are built in the laminate, it is possible to reduce the amount of laid-out wiring required for connecting the component elements. Therefore, it is possible to reduce the signal loss in every wire and to improve a noise index.

Fig. 4 is a block diagram of one embodiment according to the receiving module of the present invention. A receiving module 30 comprises a low-noise amplifier 31, a three-terminal filter 32, a double-balanced mixer 33, and first to fifth terminals P1 to P5. The three-terminal filter 32 and the double-balanced mixer 33 are sequentially connected to the output of the low-noise amplifier 31.

Note that an equivalent circuit of the three-terminal filter 32 has the same circuit configuration as that of the equivalent circuit of the three-terminal filter 10 in Fig. 1.

Next, the description turns to an operation of the receiving module 30, The low-noise amplifier 31 amplifies a high-frequency signal RF', which is received by an antenna (not shown) connected to the stage previous to the first terminal P1. Thereafter, the amplified signal is inputted to the three-terminal filter 32, and then converted into the first and second high-frequency signals RF1 and RF2. After that, the double-balanced mixer 33 mixes the first and second high-frequency signals RF1 and RF2 to first and second local oscillation signals Lo1 and Lo2, which are transmitted from a local oscillating circuit Lo by way of a balun BAL1, thereby generating first and second intermediate frequency signals IF1 and IF2. The first and second intermediate frequency signals IF1 and IF2 are inputted to a demodulating unit DEM through a balun BAL2.

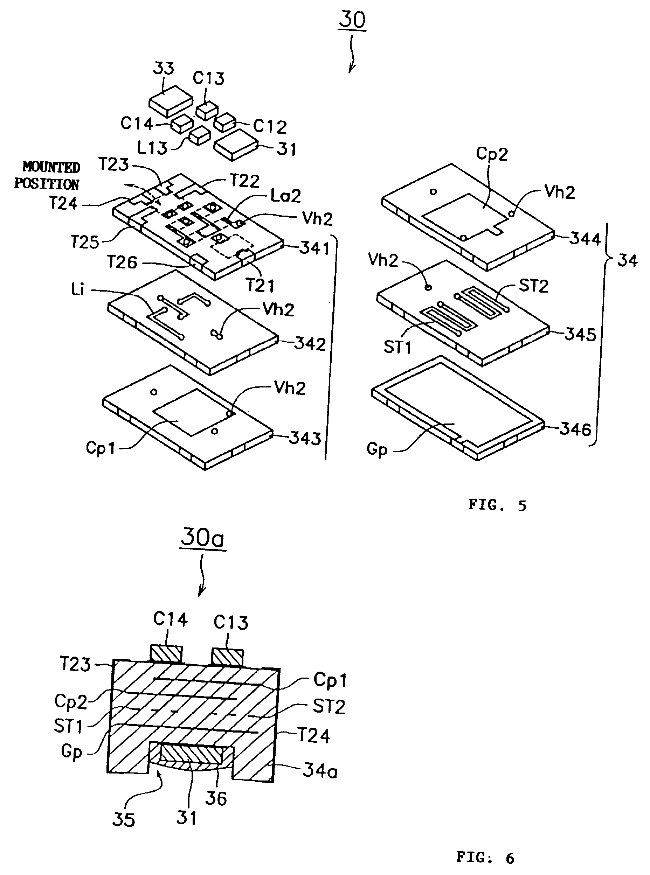

Fig. 5 is an exploded perspective view showing only the receiving module in Fig. 4. It is noted that the same reference numerals are used for the same or equivalent portions as those in Fig. 2, and the detailed description thereof is omitted.

The receiving module 30 has a laminate 34, and are provided with external terminals T21 to T26 which extend from an upper surface of the laminate 34 to a lower surface thereof. In this case, the external terminals T21 to T25 correspond to the first terminal P1, third terminal P3, fifth terminal P5, fourth terminal P4, and second terminal P2 (in the receiving module 30 in Fig. 4), respectively. The external terminal T26 corresponds to a ground terminal.

For instance, the laminate 34 is formed by sequentially laminating and firing first to sixth dielectric layers 341 to 346 made of low-temperature co-fired ceramics, which essentially contains a barium oxide, aluminum oxide, and silica and can be fired at a temperature within the range 850°C to 1000°C.

Formed onto the first dielectric layer 341 are the low-noise amplifier 31 and double-balanced mixer 33 comprising ICs, an inductor L23 and the capacitors C22 to C24 of the three-terminal filter 32 (described in fig.4) comprising chip parts, and a land La2 for mounting the capacitors C22 to C24. Wiring Li for connection of the above components is formed onto the second dielectric layer 342.

Further the capacitor electrodes Cp1 and Cp2 are formed onto the third and fourth dielectric layers 343 and 344. Strip line electrodes ST1 and ST2 are formed onto the fifth dielectric layer 345.

Furthermore, the ground electrode Gp is formed onto the sixth dielectric layer 346. Several via-hole electrodes Vh2 are formed through the first to fifth dielectric layers 341 to 345 so as to pierce the dielectric layers 341 to 345.

The inductors L21 and L22 of the three-terminal filter 32 are configured of the strip line electrodes ST1 and ST2 and the ground terminal Gp, respectively. The capacitor C21 of the three-terminal filter 32 is configured of the capacitor electrodes Cp1 and Cp2 which sandwich the third dielectric layer 343 and face each other.

Connected through the via-hole electrodes Vh2 built in the laminate 34 are the strip line electrodes ST1 and ST2 and the capacitor electrodes Cp1 and Cp2 which are built in the laminate 34, low-noise amplifier 31 and double-balanced mixer 33 which are mounted to the laminate 34, and the inductor L23 and the capacitor C22 to C24 which are built in the laminate 34.

Fig. 6 is a cross-sectional view showing a modified example of the receiving module in Fig. 5. Compared with the receiving module 30 in the embodiment in Fig. 5, a receiving module 30a is different therefrom in that the low-noise amplifier 31 and the double-balanced mixer 33 (not shown in Fig. 6) are mounted in the cavity 35 which is provided on the bottom of a laminate 34a.

The cavity 35 is formed by laminating a further dielectric layer (not shown) that is provided with an opening which produces the cavity 35 under the sixth dielectric layer 346 in Fig. 5. After mounting the low-noise amplifier 31 and the double-balanced mixer 33, the cavity 35 is sealed by being filled with resin 36.

According to the receiving module of the above-discussed embodiments, the low-noise amplifier and the double-balanced mixer are mounted to the laminate in which at least part of the inductors and capacitors of the three-terminal filter are built, thereby making it possible to provide wiring between the low-noise amplifier, three-terminal filter, and double-balanced mixer in the laminate. Accordingly, losses can be reduced and thus, it is possible to provide a receiving module having preferable receiving characteristics.

The number of parts in the receiving module of the above-discussed embodiments can be decreased to fewer than in the conventional receiving module comprising the low-noise amplifier, high-frequency filter, balun, and double-balanced mixer, thus making costs lower and the module lighter.

Moreover, according to the modified example in Fig. 6, the low-noise amplifier and/or the double-balanced mixer configured of ICs are mounted in the cavity which is provided in the laminate that comprises at least part of the inductors and capacitors of the three-terminal filter, so that the low-noise amplifier and double-balanced mixer cannot project beyond the surface of the laminate. Thus, there is smaller danger of the low-noise amplifier and the double-balanced mixer peeling off of the laminate and the reliability of the receiving module is improved and the receiving module can be made thin.

Fig. 7 is a block diagram of one example according to a portable radio apparatus of the present invention. A cellular phone 40 serving as a portable radio apparatus comprises: an antenna ANT connected to an antenna terminal (not shown specifically); a receiving unit Rx and a transmitting unit Tx which are connected to the antenna terminal via a switch SW; and a casing COV which covers the switch SW, receiving unit Rx, and transmitting unit Tx.

In this case, the receiving unit Rx has: a low-noise amplifier 41; a three-terminal filter 42; a double-balanced mixer 43; and a demodulating unit 44. The transmitting unit Tx has: a high-output amplifier 45; a band pass filter 46; a mixer 47; and a modulating unit 48. A local oscillating circuit 49 for generating a local oscillation signal is connected to one pair of input-terminals of the double-balanced mixer 43 in the receiving unit Rx, and to the mixer 47 in the transmitting unit Tx.

The three-terminal filter 42 of the receiving unit Rx in the cellular phone 40 uses the three-terminal filter 10 in Fig. 1 or the three-terminal filter 20 in Fig. 3. The low-noise amplifier 41, three-terminal filter 42, and double-balanced mixer 44 of the receiving unit Rx in the cellular phone 40 use the receiving module 30 in Fig. 5 or the receiving module 30a in Fig. 6.

The portable radio apparatus of the embodiment employs the three-terminal filter or the receiving module, with a small size and low cost, thus facilitating miniaturization and cost reduction. It is possible to prevent the receiving characteristics of the portable radio apparatus from being degraded and also to improve the reliability of the portable radio apparatus by reason of the use of the three-terminal filter or the receiving module with preferable receiving characteristics.

Incidentally, although in the above-explained embodiments of the three-terminal filter and receiving module, the dielectric layer is made of ceramics which essentially contain barium oxide, aluminum oxide, and silica, any material also suffices for the present invention so long as a dielectric constant (□r) thereof is 1 or more and, further, similar advantages can be obtained even when utilizing a material such as a ceramic having magnesium oxide and silica as main components or a fluororesin.

Although the above-discussed embodiments of the three-terminal filter comprise a one stage high-pass filter or low-pass filter, respectively, as shown in Figs. 1 and 3, it is also sufficient to make use of a high-pass filter or low-pass filter having a plurality of stages, respectively, if the necessity may arise.

Although the above embodiments of the receiving module have the three-terminal filter (in Fig. 1) which is utilized when mixing signals by the double-balanced mixer in the lower local signal, the similar advantage can be obtained by using the receiving module having the three-terminal filter (in Fig. 3) which is employed when mixing signals by the double-balanced mixer in the upper local signal.

In the above description, both the low-noise amplifier and double-balanced mixer are mounted to the laminate. However, either one may be mounted to the laminate without the other.

In the foregoing modified example of the receiving module, the cavity is filled with resin. However, the cavity may also be enclosed by a cap which contains a metallic material or ceramics, for example. In this case, the low-noise amplifier and double-balanced mixer can be mounted in a form of a bare chip, and this results in enabling the receiving module with lower cost to be realized.

According to a first aspect of the invention, a three-terminal filter comprises: an input terminal for inputting a high-frequency signal; a first output terminal for outputting a first high-frequency signal having a predetermined frequency; and a second output terminal for outputting a second high-frequency signal whose phase is inverted by 180° from a phase of the first high-frequency signal. Therefore, it is possible to remove a signal of an image frequency that is an unnecessary signal, and also to convert an unbalanced signal into a balanced signal.

Consequently, since both the filter function and a balun function are performed by one unit, the mounting area is approximately 2/3 of that with the conventional filter and balun, thereby making it possible to decrease the size of the radio apparatus. Costs can also be reduced because of decreasing the number of parts.

Preferably, the three-terminal filter comprises the inductors and capacitors provided in a laminate. Therefore it is possible to reduce an amount of laid-out wiring for connecting the component elements. Therefore, it is possible to reduce the signal loss in the wiring and to improve a noise index.

According to a second aspect of the invention, a receiving module comprises a low-noise amplifier and a double-balanced mixer, which are mounted to the laminate in which at least part of the inductors and capacitors of the three-terminal filter are provided. Therefore, wiring between the low-noise amplifier, the three-terminal filter, and the double-balanced mixer can be provided in the laminate, thus making it possible to decrease signal losses due to the wiring, thus providing a receiving module having preferable receiving characteristics.

Further, preferably, it is possible to decrease the number of parts in the receiving module, as compared with the conventional receiving module comprising the low-noise amplifier, high-frequency filter, balun, and double-balanced mixer. Thus, low costs can be realized and the weight can be made light.

Preferably, a receiving module comprises a cavity having the low-noise amplifier and the double-balanced mixer, which is provided to the laminate comprising at least part of the inductors and capacitors of the three-terminal filter. Therefore, the low-noise amplifier and the double-balanced mixer are prevented from projecting beyond the surface of the laminate. As a result, the danger is decreased that the low-noise amplifier and the double-balanced mixer will be torn off from the laminate. The reliability of the receiving module is improved and the receiving module can also be made thin.

According to a third aspect of the invention, a portable radio apparatus uses a three-terminal filter with a small size and low cost. Therefore, it is possible to facilitate the realization of miniaturization of the portable radio apparatus and low cost thereof.

According to a fourth aspect of the invention, a portable radio apparatus uses a receiving module with a small size and low cost. Therefore, it is possible to facilitate the realization of miniaturization of the portable radio apparatus and low cost thereof. A receiving module with preferable receiving characteristics is also used and, thus, it is possible to prevent the receiving characteristics of the portable radio apparatus from deteriorating and to improve the reliability of the portable radio apparatus.

Although embodiments of the invention have been described, it is understood that the invention is not limited to those embodiments, but extends to other modifications, variations, and other uses that may occur to those having the ordinary level of skill in the art.

## Claims

1. A three-terminal filter having a plurality of inductors (L11, L12, L13, L21, L22, L23) and a plurality of capacitors (C11, C12, C13, C14, C21, C22, C23, C24), comprising:
an input terminal (Pi) for inputting a high-frequency signal;
a first output terminal (Po1) for outputting a first high-frequency signal;
a second output terminal (Po2) for outputting a second high-frequency signal whose phase is inverted by 180° from a phase of said first high-frequency signal.

2. A filter according to claim 1, wherein said three-terminal filter comprises a laminate (11) constructed by laminating a plurality of dielectric layers (111, 112, 113, 114, 115), wherein at least one (L11, L12) of said inductors (L11-L13; L21-L23) comprises a strip line electrode (ST1, ST2), which is provided on one (114) of said dielectric layers (111, 115), and at least one (C11) of said capacitors (C11-C14) comprises a plurality of capacitor electrodes (Cp1, Cp2), which are provided therein, sandwiching one (112) of said dielectric layers (111-115) and facing each other.

3. A filter according to claim 1 or 2, wherein one (L13; L23) of said inductors (L11-L13; L21-L23) interconnects said first and second output terminals (Po1, Po2) so as to provide said 180° phase difference.

4. A receiving module comprising a low-noise amplifier (31), a double-balanced mixer (33), and a three-terminal filter (32); wherein said three-terminal filter (32) comprises a laminate (34; 34a) constructed by laminating a plurality of dielectric layers (341, 342, 343, 344, 345, 346) wherein at least one (L11, L12) of said inductors (L11-L13) comprises a strip line electrode (ST1, ST2), which is provided on one of said dielectric layers (345), and at least one (C11) of said capacitors (C11, C12, C13, C14) comprises a plurality of capacitor electrodes (Cp1, Cp2), which are provided therein, sandwiching one (343) of said dielectric layers (341-346) and facing each other; and
wherein said laminate (34; 34a), which is comprised in said three-terminal filter (32), has at least one of said low-noise amplifier (31) and said double-balanced mixer (33).

5. A module according to claim 4, wherein said laminate (34a) comprises a cavity (35) having therein said at least one of said low-noise amplifier (31) and said double-balanced mixer (33).

6. A radio apparatus comprising:
an antenna terminal;
a low-noise amplifier (41) for receiving an input signal from said antenna terminal;
a three-terminal filter (42) having a plurality of inductors (L11-L13; L21-L23) and a plurality of capacitors (C11-C14; C21-C24), comprising:
an input terminal (Pi) for inputting a high-frequency signal;
a first output terminal (Po1) for outputting a first high-frequency signal;
a second output terminal (Po2) for outputting a second high-frequency signal whose phase is inverted by 180° from a phase of said first high-frequency signal;
a double-balanced mixer (43) for receiving said first and second high-frequency signals; and
a demodulating unit (44) for receiving and demodulating an output of said double-balanced mixer.

7. A radio apparatus according to claim 6, wherein said three-terminal filter (42) comprises a laminate (11) constructed by laminating a plurality of dielectric layers (111-115), wherein at least one (L11, L12) of said inductors (L11-L13) comprises a strip line electrode (ST1, ST2), which is provided on one (114) of said dielectric layers (111-115), and at least one (C11) of said capacitors (C11-C14) comprises a plurality of capacitor electrodes (Cp1, Cp2), which are provided therein, sandwiching one (112) of said dielectric layers (111-115) and facing each other.

8. A radio apparatus comprising:
an antenna terminal;
a receiving module (30; 30a) for receiving an input signal from said antenna terminal;
said receiving module (30; 30a) comprising a low-noise amplifier (31), a double-balanced mixer (33), and a three-terminal filter (32); wherein said three-terminal filter (32) comprises a laminate (34; 34a) constructed by laminating a plurality of dielectric layers (341-346), wherein at least one (L11, L12) of said inductors (L11-L13) comprises a strip line electrode (ST1, ST2), which is provided on one of said dielectric layers (345), and at least one (C11) of said capacitors (C11-C14) comprises a plurality of capacitor electrodes (Cp1, Cp2), which are provided therein, sandwiching one (343) of said dielectric layers (341-346) and facing each other;
wherein said laminate (34; 34a) , which is comprised in said three-terminal filter (32), has at least one of said low-noise amplifier (31) and said double-balanced mixer (33); and
a demodulating unit, for receiving and demodulating an output of said receiving module.

9. A radio apparatus according to claim 8, wherein said laminate (34a) comprises a cavity (35) having therein said at least one of said low-noise amplifier (31) and said double-balanced mixer (33).
